# EUROPEAN PATENT APPLICATION

(11) **EP 2 421 011 A1**
(43) Date of publication of application: **22.02.2012**
(21) Application number: 10173438.2
(22) Date of filing: 19.08.2010
(51) Int. Cl.: H01F 5/00, H01F 17/00, H01F 41/04

(54) **Symmetrical inductor**

(71) Applicant: NXP B.V., 5656 AE Eindhoven (NL)
(72) Inventor: Nazarian Alexe,Levan, Redhill, Surrey RH1 1DL (GB); Stephens, Daniel, Redhill, Surrey RH1 1DL (GB); Tiemeijer, Luka, Frederik, Redhill, Surrey RH1 1DL (GB)
(74) Representative: Burton, Nick

(57) **Abstract**

A symmetrical inductor having at least one inductor turn. Each inductor turn has a plurality of separate conductive paths having substantially equal inductance. The inductor also comprises a plurality of crossing points. At each crossing point, some of the conductive paths within a given inductor turn cross over each other to change the order in which they appear within the inductor turn.

## Description

### BACKGROUND OF THE INVENTION

This invention relates to a symmetrical inductor.

It is well known to use inductors to implement voltage controlled oscillators in integrated circuits (ICs) comprising transceivers. The inductance required for such applications is typically a few nH, although inductor designs should be tailorable to the specific application. It desirable that the quality factor provided by inductors used for these applications should be as high as possible. It is also desirable that the inductor used should produce a low net magnetic field, so as to minimise magnetic coupling with neighbouring components (including other inductors) in the IC. Examples of inductors which seek to produce a low net magnetic field are set out in WO1998005048, W02004012213, W02005096328, and W02006105184.

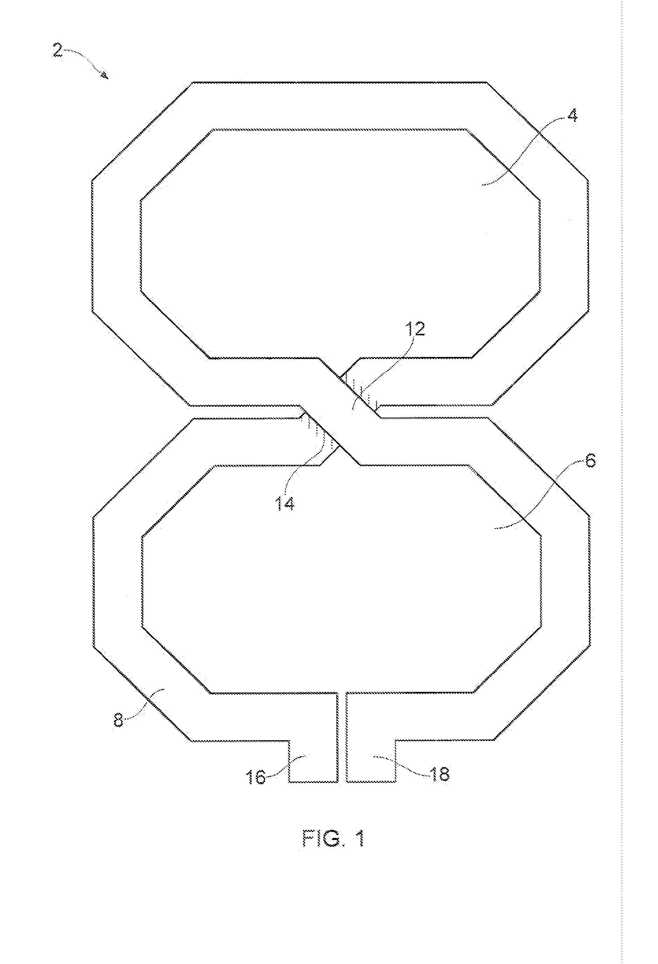

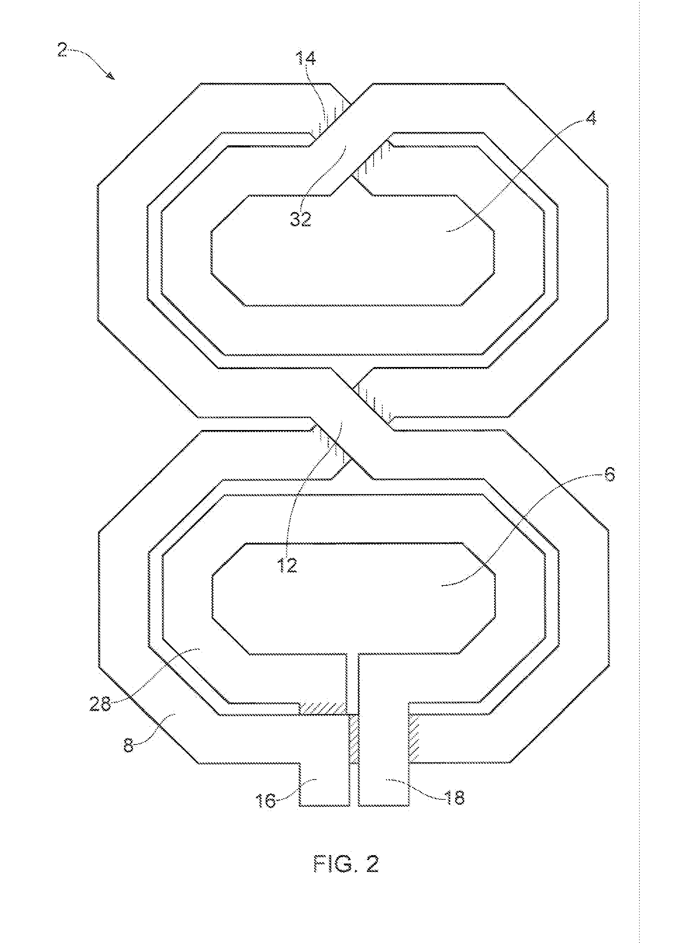

Figures 1 and 2 show examples of inductors 2 which are 8-shaped, with the aim of minimising the net magnetic field that is produced. The inductor 2 of Figure 1 is a single turn inductor, while the inductor 2 of Figure 2 is a two-turn inductor. Each example inductor 2 has a pair of terminals 16, 18, and a conductive track which extends between the terminals 16, 18 to define the inductor turn(s) 8, 28. The inductor turn(s) 8, 28 define first and second loop portions 4, 6.

At the centre of the 8-shaped inductors 2 there is a folding point 12, at which the conductive track of the inductor turn crosses over itself so that the first loop portion 4 is folded with respect to the second loop portion 6. In this way, it is the direction of the field passing through the first loop portion is opposite to the direction of the field passing through the second loop portion 6. These fields have a tendency to appear cancel to zero in the far field. Moreover, the magnitude of the field passing through each loop portion is less than the magnitude required in the case of, for example, a circular inductor not having a folding point 12. Both of these factors lessen the net magnetic field produced by the inductor.

In the case of the two-turn inductor 2 shown in Figure 2, further crossing points can be provided such as the crossing point 32 at which the conductive track crosses over itself, to accommodate the additional inductor turn. The crossing points 32 can be provided with insulation 14, to electrically isolate the conductive track at the point it crosses over itself.

One limitation on the performance of an inductor arises from a phenomenon known as the skin effect, which occurs in all conductors carrying high frequency currents. The skin effect occurs due to the fact that the surface of the conductor generally has a lower inductance than the core. Under high frequency operation, the inductive part of impedance of the conductor dominates, and because of this, the current in the conductor chooses the path of minimum inductance. As a result, with increasing frequency, the conductive area decreases and moves further toward the surface of the conductor. This in turn results in an increase of the resistance of the conductor. In the case of an inductor, this increased resistance gives rise to a lowering in quality factor. For example, in the case of an 8-shaped inductor, it is estimated that the skin effect can lead to a reduction in quality factor of 25-30%.

The example inductors shown in Figures 1 and 2 are substantially symmetrical. An example of a non-symmetrical spiral inductor is described in W02003015110.

### SUMMARY OF THE INVENTION

Aspects of the invention are set out in the accompanying independent and dependent claims. Combinations of features from the dependent claims may be combined with features of the independent claims as appropriate and not merely as explicitly set out in the claims.

According to an aspect of the invention, there is provided a symmetrical inductor comprising:
at least one inductor turn, each inductor turn comprising a plurality of separate conductive paths having substantially equal inductance; and
a plurality of crossing points at which some of the conductive paths within a given inductor turn cross over each other to change the order in which they appear within said inductor turn.

Compared to known inductor designs, the turns of an inductor according to this invention are divided into a plurality of separate conductive paths. Also, by providing a series of crossing points in the inductor, the layout of the conductive paths can be tailored to ensure that the inductance of each separate conductive path in a given inductor turn is substantially equal. This in turn ensures that current flows in all of the conductive paths, without favouring those conductive paths having lower inductance than the others.

The effect of providing multiple conductive paths having substantially equal inductance in each inductor turn is to mitigate against the skin effect described above. This is because high frequency currents in the inductor turn(s) are provided with a larger area effectively used for current flow, owing to the fact that the combined area of the separate current paths is greater than that of inductors of the kind described herein in relation to Figures 1 and 2. The decreased AC resistance at high frequencies associated with this larger effective area for current flow more than compensates for the fact that the less conductive material is used in the inductor turns (compared to inductors of the kind shown in Figures 1 and 2) and leads to an increase in the quality factor of the inductor.

In one embodiment, the separate conductive paths can terminate at a common terminal or terminals. This can facilitate a construction in which the separate conductive paths are equivalent, having the required substantially equal inductances. In some examples, the terminal or terminals can be positioned to allow connection to a centre tap.

In one embodiment, the conductive paths have equal inductance to within a tolerance of 0.1%. More particularly, the conductive paths can have equal inductance to within a tolerance of 0.001%.

The conductive paths in each inductor turn can run substantially parallel, to avoid any local variations in current or field density.

The inductor can be an 8-shaped inductor. The inductor can include a plurality of inductor turns.

In some examples, the inductor can be provided with a centre tap.

Example inductors having large numbers of separate conductive paths require a layout having more crossing points. This is to allow the paths to retain substantially equal inductances, thereby to maintain the overall symmetry of the inductor. However, crossing points introduce additional capacitance between the conductive paths. Accordingly, for optimal performance, there is a balance to be held between increasing the number conductive paths to counteract the skin effect, and avoiding a proliferation of crossing points. In accordance with an embodiment of the invention, it has been found the optimal number of conductive paths in each inductor turn is four.

According to another aspect of the invention, there is provided a voltage controlled oscillator (VCO) comprising an inductor of the kind described above.

According to a further aspect of the invention, there is provided a transceiver comprising an inductor of the kind described above.

According to another aspect of the invention, there is provided an integrated circuit comprising an inductor of the kind described above.

### BRIEF DESCRIPTION OF THE DRAWINGS

Embodiments of the present invention will be described hereinafter, by way of example only, with reference to the accompanying drawings in which like reference signs relate to like elements and in which:
Figure 1 shows a known kind of single turn inductor;
Figure 2 shows a known kind of two-turn inductor;
Figure 3 shows a single turn inductor according to an embodiment of the invention;
Figure 4 shows a two-turn inductor according to an embodiment of the invention;
Figure 5 shows a single turn inductor according to an embodiment of the invention; and
Figure 6 shows a two-turn inductor according to an embodiment of the invention.

### DETAILED DESCRIPTION

Embodiments of the present invention are described in the following with reference to the accompanying drawings.

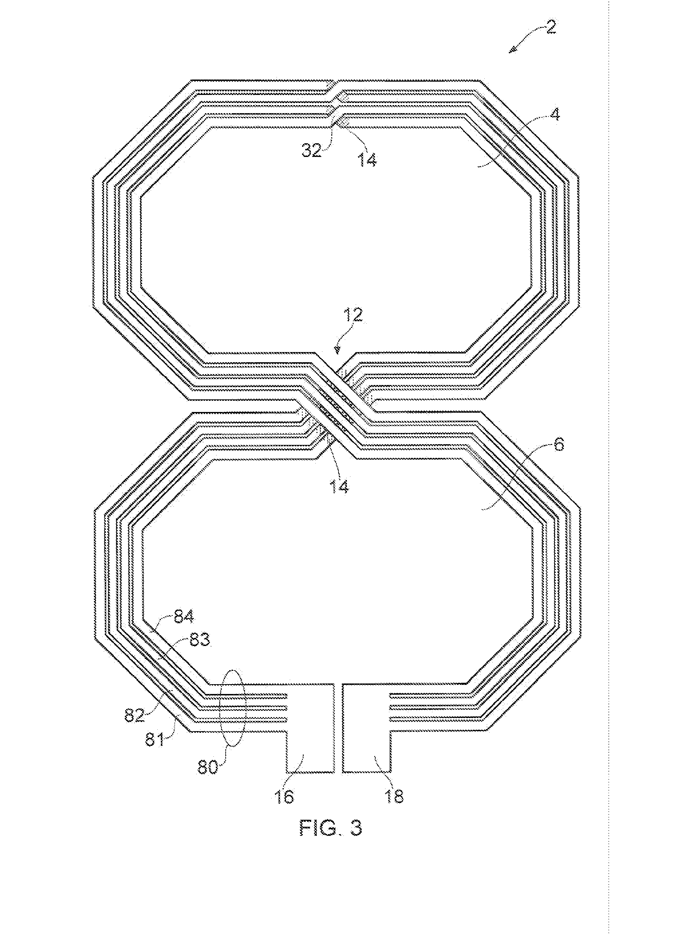

A first embodiment of the invention is shown in Figure 3. In this embodiment, there is provided a symmetrical, 8-shaped inductor 2 having a single turn 80. The layout of the inductor 2 in this embodiment may be thus compared with the layout of the know conductor shown in Figure 1. The inductor 2 includes the pair of terminals 16, 18 at which the inductor turn 80 terminates at either end. In common with the known inductor described above in relation to Figure 1, the inductor 2 in this embodiment includes a folding point 12, at which the inductor turn 80 crosses over itself, so that a first loop portion 4 of the inductor 2 is folded with respect to a second loop portion 6. These two loop portions together form the "8" shape of the inductor 2.

As described herein, in accordance with the invention, an inductor is provided in which each inductor turn includes a plurality of separate conductive paths having substantially equal inductance. This mitigates against the skin effect described above, as a high frequency currents in the inductor turn(s) are provided with a larger area for current flow. The decreased AC resistance associated with this large area for current flow leads to an increase in the quality factor of the inductor.

In the example shown in Figure 3, the inductor turn 80 is divided into four separate conductive paths 81, 82, 83, 84. As shown in Figure 3, each of the conductive paths 81, 82, 83, 84 terminates at the terminals 16 and 18.

Also as shown in Figure 3, in this example, the conductive paths 81, 82, 83, 84 are substantially parallel throughout the inductor 2, thereby to ensure homogeneity of the currents and fields associated with each conductive path. By providing conductive paths that are substantially parallel, that have appropriately placed crossing points, and that terminate at the common terminals such as terminals 16, 18 shown in Figure 3, it becomes possible to manufacture a symmetrical inductor having separate conductive paths with substantially equal inductance to within a desired tolerance. The tolerance level to within which the conductive paths are effectively equivalent may depend upon the intended application for the inductor and/or the manufacturing process that is used. In one example, the conductive paths in an inductor of the kind shown in Figures 3-6 of this application may have equal inductances to within a tolerance of 0.1 %. In another example, in which higher tolerance levels are required for a particular application, the conductive paths may have equal inductances to within a tolerance of 0.001%.

As described herein, an effect of dividing the inductor turn 80 into a plurality of conductive tracks 81, 82, 83, 84 is to increase the surface area available within the inductor turn 80 for current flow, thereby to counteract the skin effect. Although splitting the inductor turn 80 into a plurality of separate paths 81,82,83,84 has the benefit of counteracting the skin effect, it does complicate the layout of the inductor 2. In particular, as the inductor 2 is a symmetrical inductor, the symmetry of the inductor turn 80 and the conductive paths 81, 82, 83, 84 within the inductor turn 80 should be ensured. In particular, the layout of the inductor 2 must be designed such that the conductive paths 81, 82, 83, 84 have substantially equal inductance, whereby current can flow substantially equally within those paths. If the inductances of the conductive paths within a given inductor turn were not equal to within a given tolerance, then current would tend to flow only in those paths having lower inductance, effectively limiting the amount of current which can flow in the inductor turn.

In order to produce such a layout, in accordance with an embodiment of the invention, the inductor 2 and in particular the conductive paths 81, 82, 83, 84 of the inductor 2 are provided with one or more crossing points 32. Crossings points are points at which a conductive path in the inductor turn 80 crosses over another conductive path in the inductor turn 80. Additionally, at each crossing point 32, the ordering of the plurality of the conductive paths changes to some degree. In particular, at each crossing point, the two conductive paths associated with the crossing point may effectively swap places within the inductor turn 80. It is noted that folding points or crossing points of the kind described in relation to Figures 1 and 2 are merely points at which the (entire) inductor turn crosses over itself - these points are not therefore crossing points at which conductive paths within an inductor turn cross over each other.

As shown in Figure 3, since each crossing point 32 comprises a location at which a first conductive path crosses over a second conductive path, insulation 14 may be provided at the crossing point 32 to prevent conductive contact being made between the two conductive paths. It will be appreciated that because the conductive paths associated with each crossing point 32 come into close proximity with each other at the location of the crossing point 32, each crossing point 32 has associated therewith an increase in capacitance between those conductive paths. The increase in capacitance from the crossing points 32 in the inductor 2 sum up to increase the overall capacitance of the inductor 2, which may have a detrimental effect on the Q-factor of the inductor 2.

Accordingly, although it is possible to provide crossing points 32 of the kind described herein, it is not desirable to provide too many crossing points 32, or to provided unnecessary crossing points. Optimally, a sufficient number of crossing points should be provided to allow the resistance and inductance of the conductive paths to be equal to the extent that the inductor retains it symmetry to within a given tolerance, without overly increasing mutual capacitance between the conductive paths in the inductor turn 80.

As mentioned above, the purpose of the crossing points 32 is to allow the conductive paths in the inductor turn 80 to be laid out in such a way to ensure symmetry in the inductor 2. The number of crossing points which can be used in this way depends upon the number of inductor turns 80 provided with the inductor and also on the number of the conductive paths provided within each inductor turn.

In the example of Figure 3, two crossing points 32 are provided (in addition to, of course, the folding point 12) to ensure symmetry. In a single turn 8-shaped inductor having four conductive paths 81, 82, 83, 84, this is the minimum number of crossing points 32 that can be used in this way to ensure symmetry.

As described above, it has been found that the optimal number of conductive paths in each inductor turn 80 is four. For this reason, each of the examples shown in Figures 3, 4, 5 and 6 of this application include inductor turns having four conductive paths. Inductors having different numbers of conductive paths per inductor turn are nevertheless envisaged.

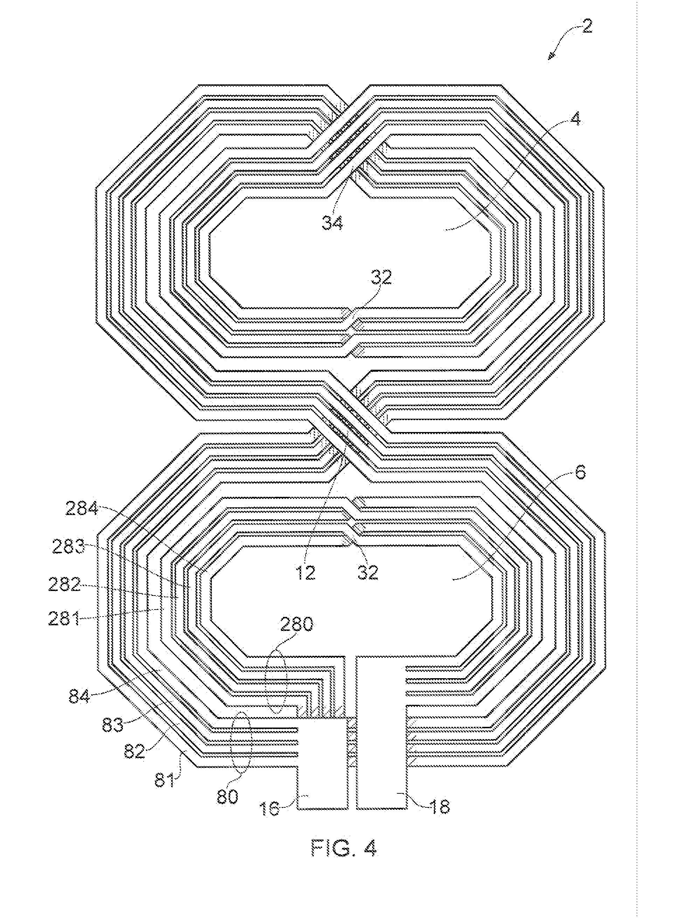

A second example inductor 2 in accordance with an embodiment of the invention is shown in Figure 4. The inductor 2 shown in Figure 4 is an 8-shaped inductor having two inductor turns 80, 280. As described above in relation to Figure 3, the inductor 2 in Figure 4 includes terminals 16, 18, at which the inductor turn 80 and the conductive paths 81, 82, 83, 84 of the inductor turn 80 terminates. In order to incorporate the second inductor turn 280 into the inductor 2, the layout includes a first folding point 12 (which is similar to the folding point described above in relation to Figure 3), and a second folding point 34. In addition to the folding points 12 and 34, as shown in Figure 4, a number of crossing points 32 are provided. In particular, two crossing points are provided for each the inductor turn 80, 280 in the inductor 2, (whereby a total of four crossing points 32 are provided).

As with the example described above in relation to Figure 3, the purpose of the four crossing points 32 in the inductor 2 shown in Figure 4 is to allow the layout of the conductive paths in the inductor turns of the inductor 2 to be determined in such a manner that the resistance and inductance of each conductive path is substantially equal to the other conductive paths in that inductor turn.

As shown in Figure 4, the inductor turn 80 in the inductor 2 includes four conductive paths 81, 82, 83, 84. The second inductor turn 280 in Figure 4 includes four further conductive paths 281, 282, 283, 284. In total therefore, the inductor 2 in Figure 4 includes eight conductive paths, four in each inductor turn. As shown also in Figure 4, insulating material may be provided at each crossing point 32, at the folding points 12 and 34 and also in the vicinity of the terminals 16 and 18, to ensure that there is no short circuiting between the conductive paths where they cross over each other or come into close proximity with other conductive portions of the inductor 2.

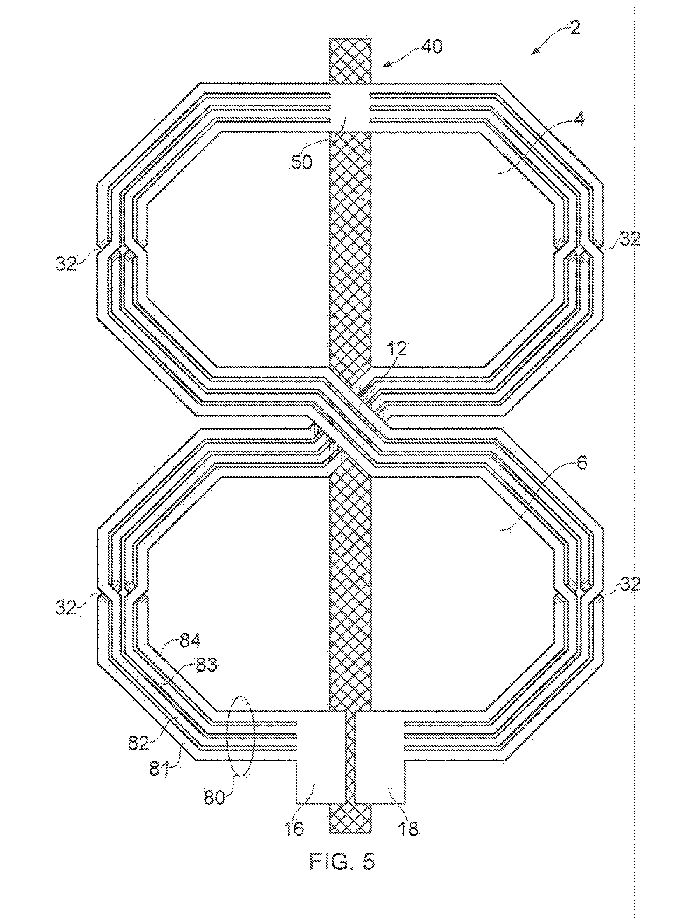

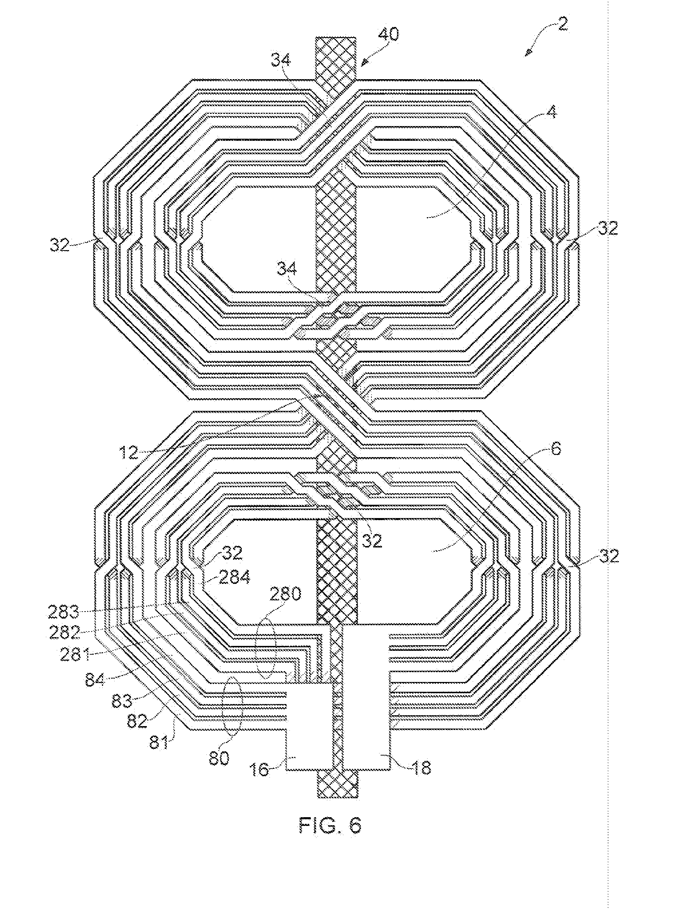

Two further examples of inductors in accordance with embodiments of this invention are shown in Figures 5 and 6. The example in Figure 5 is a single turn 8-shaped inductor 2. The example in Figure 6 is an 8-shaped inductor 2 having two inductor turns. Both examples in Figures 5 and 6 include a centre tap 40. Moreover, both inductors shown in Figures 5 and 6 include modifications to the layout of the inductor turns and conductive paths therein to accommodate the incorporation of the centre tap 40. These modifications may be seen by comparing the layout of the conductor in Figure 5 with the layout of the conductor in Figure 3 and also by comparing the layout of the inductor in Figure 6 with the inductor in Figure 4.

A first modification in both of the inductors shown in Figures 5 and 6 is that the layouts of the conductive paths in those inductors include a greater number of crossing points 32. The increase in the number of crossing points 32 results from the increase in complexity of the layout of the inductor implicated by the inclusion of the centre tap 40. As described above, a proliferation of crossing points 32 in the inductor 2 may result in an increase in the overall mutual capacitance of the conductive paths in the inductor 2, leading to a reduced Q-factor for the inductor 2. However, the examples of Figures 5 and 6 at least show that it is possible to incorporate centre taps into single turn and multiple turn 8-shaped inductors having a plurality of conductive paths in each inductor turn, in accordance with the embodiments of this invention.

A further modification, which is made in the case of the inductor of Figure 5, is the provision of a further terminal 50. As shown in Figure 5, the terminal 50 is a point at which each of the conductive paths 81, 82, 83, 84 in the inductor turn 80 terminate. Moreover, the terminal 50 is connected to the centre tap 40. Accordingly therefore, the terminal 50 allows each of the conductive paths 81, 82, 83, 84 to be connected to the centre tap 40 in such a way that their path lengths remain substantially equal (which in turns helps to ensure the symmetrical nature of the inductor 2).

Inductors of the kind described herein may be incorporated into devices such as voltage controlled oscillators (VCOs) in transceivers. For example, the inductors described herein may be incorporated into integrated circuits associated with a transceiver or VCO.

Accordingly, there has been described a symmetrical inductor having at least one inductor turn. Each inductor turn has a plurality of separate conductive paths having substantially equal inductance. The inductor also comprises a plurality of crossing points. At each crossing point, some of the conductive paths within a given inductor turn cross over each other to change the order in which they appear within the inductor turn.

Although particular embodiments of the invention have been described, it will be appreciated that many modifications/additions and/or substitutions may be made within the scope of the claimed invention.

## Claims

1. A symmetrical inductor comprising:
at least one inductor turn, each inductor turn comprising a plurality of separate conductive paths having substantially equal inductance; and
a plurality of crossing points at which some of the conductive paths within a given inductor turn cross over each other to change the order in which they appear within said inductor turn.

2. The inductor of claim 1, wherein the conductive paths in each inductor turn are substantially parallel.

3. The inductor of claim 1 or claim 2, wherein the conductive paths terminate at a common terminal or terminals.

4. The inductor of any preceding claim, wherein the conductive paths have equal inductance to within a tolerance of 0.1%.

5. The inductor of claim 4, wherein the conductive paths have equal inductance to within a tolerance of 0.001%.

6. The inductor of any preceding claim, wherein the inductor is an 8-shaped inductor.

7. The inductor of any preceding claim comprising a plurality of inductor turns.

8. The inductor of any preceding claim comprising a centre tap.

9. The inductor of any preceding claim, wherein each inductor turn comprises four conductive paths.

10. A voltage controlled oscillator (VCO) comprising the inductor of any preceding claim.

11. A transceiver comprising the inductor of any of claims 1 to 9.

12. An integrated circuit comprising the inductor of any of claims 1 to 9.

## Amended claims

### Amended claims in accordance with Rule 137(2) EPC.

**1.** A symmetrical inductor comprising:
at least one inductor turn (80,280), wherein if there is one inductor turn (80) it is a conductive path following the shape of the inductor between a pair of terminals (16,18), and if there is a number of inductor turns (80,280), they are electrically in series between the pair of terminals (16,18) and follow the shape of the inductor said number of times,
wherein each inductor turn (80,280) comprises a plurality of separate conductive paths (81,82,83,84; 281,282,283,284) electrically connected in parallel at the pair of terminals (16,18);
**characterised in that** the conductive paths have substantially equal inductance and the inductor further comprises a plurality of crossing points (32) at which some of the conductive paths within a given inductor turn cross over each other to change the order in which they appear within said inductor turn.

**2.** The inductor of any preceding claim, wherein the conductive paths (81,82,83,84; 281,282,283,284) have equal inductance to within a tolerance of 0.1%.

**3.** The inductor of claim 2, wherein the conductive paths (81,82,83,84; 281,282,283,284) have equal inductance to within a tolerance of 0.001%.

**4.** The inductor of any preceding claim, wherein the inductor is an 8-shaped inductor.

**5.** The inductor of any preceding claim comprising a plurality of inductor turns.

**6.** The inductor of any preceding claim comprising a centre tap (40).

**7.** The inductor of any preceding claim, wherein each inductor turn (80,280) comprises four conductive paths (81,82,83,84; 281,282,283,284).

**8.** A voltage controlled oscillator (VCO) comprising the inductor of any preceding claim.

**9.** A transceiver comprising the inductor of any of claims 1 to 7.

**10.** An integrated circuit comprising the inductor of any of claims 1 to 7.
